# EUROPEAN PATENT APPLICATION

(11) **EP 2 040 289 A2**
(43) Date of publication of application: **25.03.2009**
(21) Application number: 08250419.2
(22) Date of filing: 05.02.2008
(51) Int. Cl.: H01L 21/60, H01L 23/498

(54) **Packaging substrate structure and method for manufacturing the same**

(30) Priority: 19.09.2007 TW 96134809
(71) Applicant: Phoenix Precision Technology Corporation, Hsin-Chu (TW)
(72) Inventor: Hsu, Shih-Ping, Hsinchu (TW)
(74) Representative: Blatchford, William Michael

(57) **Abstract**

The present invention relates to a packaging substrate and a method for manufacturing the same. The packaging substrate comprises: a substrate body (30), wherein a surface thereof has a circuit layer comprising a plurality of circuits (33) and a plurality of conductive pads (34), and the conductive pads are higher than the circuits; and an insulating protection layer (37) disposed on the surface of the substrate body, wherein the insulating protection layer has a plurality of openings (371) exposing the conductive pads, and the size of the openings is larger than or equal to that of the conductive pads. Accordingly, the packaging substrate structure of the present invention can be employed in a flip-chip packaging structure of fine-pitch.

## Description

### BACKGROUND OF THE INVENTION

### 1. Field of the Invention

The present invention relates to a packaging substrate structure and a method for manufacturing the same, and, more particularly, to a packaging substrate structure suitable for application in a flip-chip packaging structure having fine pitch and a method for manufacturing the same.

### 2. Description of Related Art

As performance of semiconductor processes is advanced, semiconductor chips formed thereby have more and stronger functions and tend towards complexity. At the same time, amounts of transmission data of semiconductors increase more and more. Therefore, pins of semiconductors have to increase in accordance with the above-mentioned.

Inasmuch as chip techniques have developed towards high frequency and larger amounts of pins, conventional wire bonding has failed to satisfy demands of conductivity. Compared with conventional wire bonding, a flip-chip process is a technique that a chip faces downward to conduct a substrate by means of solder bumps. Besides, I/O pins can be distributed on the whole surface of the chip so that advantages can be achieved as follows: large increase on amounts of signal input points and output points of the chip, shortening of transmission path of signals, decrease in interference of noises, promotion of heat diffusivity, and compressing package volume. Hence, the flip-chip process has already become a main trend in the industry.

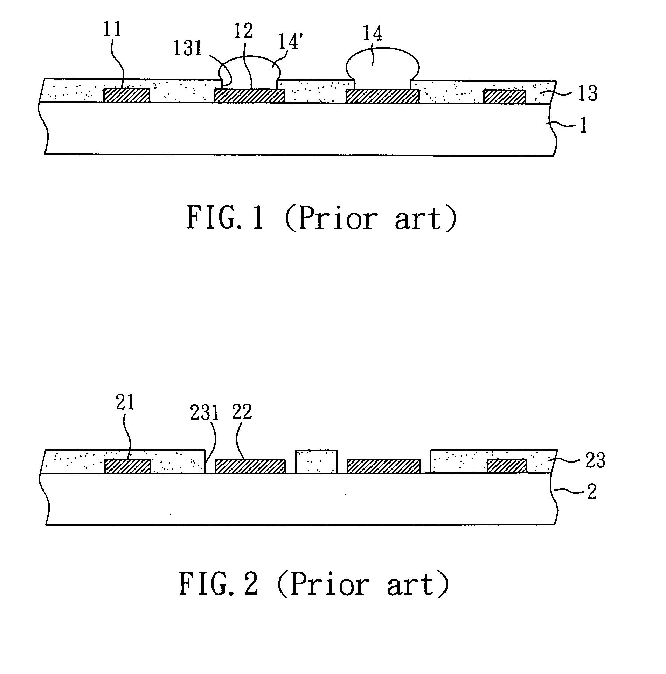

A conventional packaging substrate is shown as FIG 1. The surface of the packaging substrate 1 has a circuit layer which includes a plurality of circuits 11 together with a plurality of conductive pads 12, and a solder mask 13 which has a plurality of openings 131 exposing the conductive pads 12. The size of the openings 131 is smaller than that of the conductive pads 12. Besides, solder bumps 14,14' are formed on the surface of the conductive pads 12 by coating or printing so that the packaging substrate 1 can be conducted with a chip (not shown) by the solder bumps 14,14'.

Furthermore, another conventional packaging substrate is shown as FIG. 2. The surface of the packaging substrate 2 has a circuit layer which includes a plurality of circuits 21 together with a plurality of conductive pads 22, and a solder mask 23 which has a plurality of openings 231 exposing the conductive pads 22. The size of the openings 231 is larger than that of the conductive pads 22. Therefore, the packaging substrate 2 can be conducted to a chip (not shown) by solder bumps disposed on electrode pads of the chip.

Although the structure on the surface of the packaging substrate 1 in FIG. 1 can be used for conduction, the solder bumps 14,14' are not desirable in height and size due to difficulty in controlling those in a uniform quantity by coating or printing. Otherwise, while the packaging substrate 2 in FIG. 2 is conducted to the chip, the solder bumps 14,14' are decreased in height forasmuch as gaps between the openings 231 and the conductive pads 22 are filled with the solder bumps 14,14' so that quality of underfilling process will be influenced, resulting in a reduced reliability of products. However, if the solder bumps 14,14' are increased in height, costs are raised owing to increased amounts of solder materials.

Therefore, conventional structures and methods are not advantageous to fine bump pitch because of difficulty in controlling solder bumps to uniform height and size while forming solder bumps on solder pads. Regarding the flip-chip structure composed of a substrate and a chip having numerous I/O joints, the joints between the chip and the substrate may not be conducted wholly one by one if solder bumps do not all have a sufficient height. Alternatively, neighboring joints may be conducted together resulting from parts of solder bumps having excessively large size so as to cause otherwise acceptable chips to be scrapped by the failure of the flip-chip process. Moreover, as a semiconductor chip is developed towards advanced techniques, the strength of the chip for resisting stress becomes smaller due to lower dielectric coefficients of the chip. Even if a flip-chip structure having numerous I/O joints is obtained, the chip therein is applied with stress, more easily resulting in damage and scrap. Furthermore, when the substrate is a thin plate, the substrate is easily damaged due to uneven stress which results from solder bumps not having a uniform height and size. Therefore, the yield of the products is reduced.

In addition, as the density of electrode pads of a semiconductor chip is raised, the size of solder bumps between the chip and the substrate becomes smaller, as well as the height of the gap between the chip and the substrate, such that voids are easily produced when the gap between the chip and the substrate is filled with material of underfilling, resulting in serious problems such as popcorn of the chip.

Hence, a packaging substrate structure favoring fine pitch and without the shortcomings illustrated above is urgently required.

### SUMMARY OF THE INVENTION

In view of the above-mentioned shortcomings of conventional techniques, the object of the present invention is to provide a packaging substrate structure and a method for manufacturing the same which can be applied to fine pitch, promote quality of the underfilling process for the packaging substrate structure, and solve connective problems occurring from uneven solder bumps, to thereby improve reliability of the products and economize in costs.

In order to achieve the foregoing object, the present invention provides a packaging substrate structure comprising: a substrate body, wherein a surface thereof has a circuit layer comprising a plurality of circuits and a plurality of conductive pads, and the conductive pads are higher than the circuits; and an insulating protection layer disposed on the surface of the substrate body and having a plurality of openings exposing the conductive pads. The openings of the protective layer have a size equal to or larger than that of the conductive pads.

In the above-mentioned structure, preferably, the conductive pads have a height equal to or shorter than the insulating protection layer, and more preferably, those have a height taller than the insulating protection layer.

In the aforementioned structure, a surface finish layer can be further disposed on the conductive pads, and that can be made of one selected from the group consisting of Ni/Au, organic solderability preservatives (OSP), electroless nickel immersion gold (ENIG), Ni/Pd/Au, Sn, solder, Pb-free solder, Ag, and a combination thereof.

In the aforementioned structure, the insulating protection layer can be a solder mask or a dielectric layer.

The present invention further provides a method for manufacturing a packaging substrate comprising: providing a substrate body and forming a conductive layer on the surface of a dielectric layer of the substrate body; forming a first resistive layer on the conductive layer, and forming a plurality of open areas in the first resistive layer to expose parts of the conductive layer; forming a circuit layer comprising a plurality of circuits and a plurality of conductive pads in the open areas through the conductive layer by electroplating; forming a second resistive layer on the surfaces of the first resistive layer and the circuit layer, and forming a plurality of openings in the second resistive layer exposing the conductive pads; forming a protective layer on the surfaces of the conductive pads; removing the second resistive layer and the first resistive layer, then removing the conductive layer covered by the first resistive layer, at the same time thinning the circuits by micro-etching so that the conductive pads are higher than the circuits; removing the protective layer; and forming an insulating protection layer on the surface of the substrate body, and forming a plurality of openings in the insulating protection layer exposing the conductive pads. The size of the openings in the insulating protection layer is equal to or larger than the conductive pads.

In the method described above, the protective layer is formed by electroplating, preferably made of one selected from the group consisting of Sn, Ni, Au, Ag, Cr, and Ti.

The method illustrated above can further comprise forming a surface finish layer on the surfaces of the conductive pads, and the surface finish layer can be made of one selected from the group consisting of Ni/Au, OSP, ENIG, Ni/Pd/Au, Sn, solder, Pb-free solder, Ag, and a combination thereof.

In the method mentioned above, the insulating protection layer can be a solder mask or a dielectric layer.

Accordingly, the packaging substrate structure and a manufacturing method thereof provided in the present invention can be applied in a flip-chip structure. In particular, when circuits are developed toward fine pitch, advantages due to the conductive pads having a sufficient height are listed as follows: material of the solder bumps can be used in smaller quantity; underfilling process is easily performed; and problems such as ill underfilling or generation of voids owing to the smaller gap between the chip and the packaging substrate can be avoided.

Besides, the conductive pads formed in the present invention are easily controlled in height, and the height and size thereof are uniform. Therefore, referring to the flip-chip structure, which is composed of the substrate and the chip having numerous I/O pins, disadvantages such as disconnection between the chip and the substrate, short circuit bridges caused by conduction between two neighboring joints due to the solder bumps having too large size, otherwise faultless chips being scrapped by failure of the flip-chip process and so forth in conventional techniques can be prevented in the present invention. If the packaging substrate is a thin plate, the damage resulting from uneven stress based on the solder bumps not having a uniform height and size can also be prevented. The decrease in the yield of the products also can be avoided.

Conclusively, the packaging substrate and the manufacturing method thereof provided in the present invention can be easily obtained and performed so that the products can be promoted in yield and decreased in costs.

Other objects, advantages, and novel features of the invention will become more apparent from the following detailed description when taken in conjunction with the accompanying drawings.

### BRIEF DESCRIPTION OF THE DRAWINGS

FIG. 1 is a cross-sectional view of a conventional packaging substrate;
FIG. 2 is a cross-sectional view of another conventional packaging substrate; and
FIGs. 3A to 3I' show a flow chart in a cross-sectional view for manufacturing a packaging substrate in the embodiment of the present invention.

### DETAILED DESCRIPTION OF THE PREFERRED EMBODIMENT

Because of the specific embodiments illustrating the practice of the present invention, a person having ordinary skill in the art can easily understand other advantages and efficiency of the present invention through the content disclosed therein. The present invention can also be practiced or applied by other variant embodiments. Many other possible modifications and variations of any detail in the present specification based on different outlooks and applications can be made without departing from the spirit of the invention.

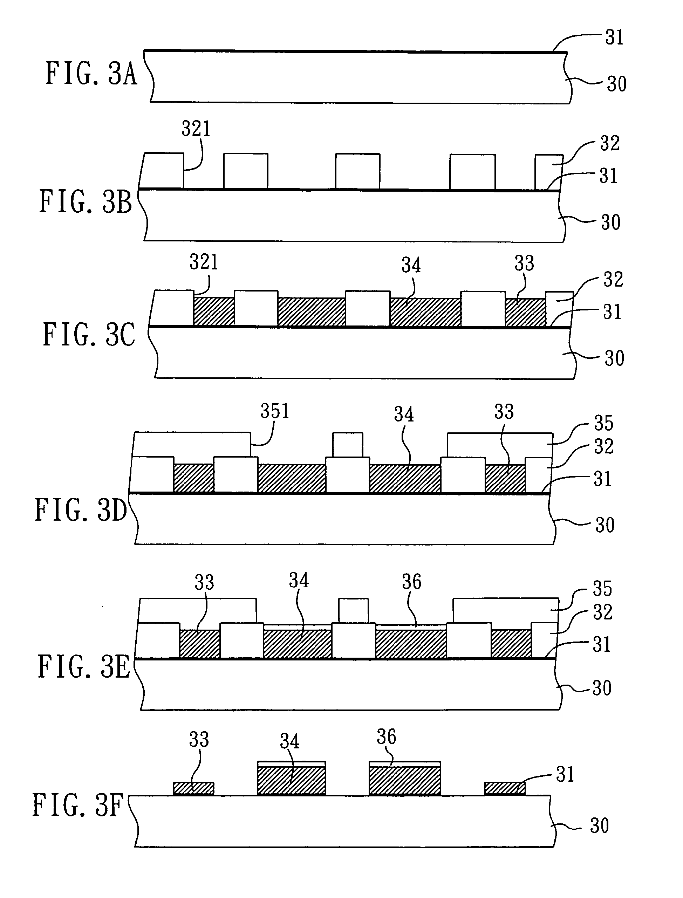

With reference to FIGs. 3A to 3I', there is a flow chart in a cross-sectional view for manufacturing a packaging substrate structure in the present invention.

First, a substrate body 30 is provided as shown in FIG. 3A. A thin conductive layer 31 made of metal or nonmetal is formed on the surface of a dielectric layer of the substrate body 30.

As shown in FIG. 3B, a first resistive layer 32 is formed on the conductive layer 31. A plurality of open areas 321 are formed in the first resistive layer 32 to expose parts of the conductive layer 31.

Subsequently, a circuit layer including a plurality of circuits 33 and a plurality of conductive pads 34 is formed in the open areas 321 by electroplating through the conductive layer 31 as shown in FIG 3C. Herein, the circuits 33 and the conductive pads 34 are made of Cu in the present embodiment.

A second resistive layer 35 is formed on the surface of the first resistive layer 32 and the surface of the circuit layer as shown in FIG 3D. A plurality of openings 351 are formed in the second resistive layer 35 exposing the conductive pads 34.

Furthermore, a protective layer 36, which is preferably made of one of the group consisting of Sn, Ni, Au, Ag, Cr, and Ti, is plated on the surfaces of the conductive pads 34 as shown in FIG. 3E. In the present embodiment, the protective layer 36 is made of Sn.

As shown in FIG. 3F, the first resistive layer 32 and the second resistive layer 35 are removed. Moreover, the conductive layer 31 covered by the first resistive layer 32 is also removed by micro etching, and at the same time, the circuit layer 33 is thinned thereby. Hence, the conductive pads 34 are higher than the circuits 33.

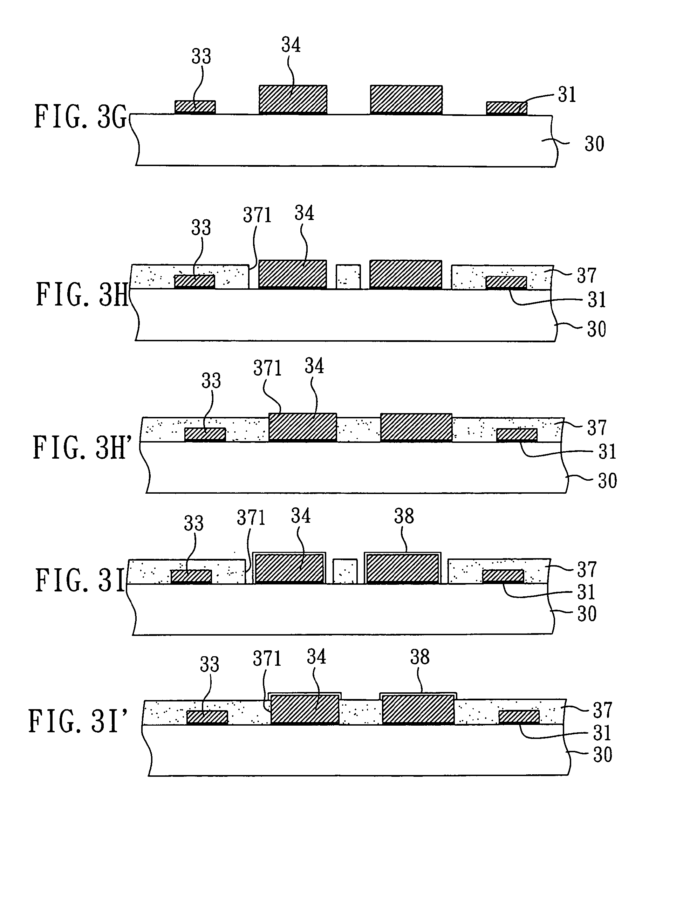

The protective layer 36 is removed as shown in FIG 3G. A structure in which the conductive pads 34 are higher than the circuits 33 is obtained.

Finally, an insulating protection layer 37 is formed on the surface of the substrate body 30 as shown in FIG. 3H. A plurality of openings 371 are formed in the insulating protection layer 37 exposing the conductive pads 34. The openings 371 have a size larger than that of the conductive pads 34. Alternatively, the openings 371 have a size equal to that of the conductive pads 34 as shown in FIG. 3H'. In the present embodiment, the conductive pads 34 have a height taller than that of the insulating protection layer 37.

The present invention further provides a structure of a packaging substrate comprising: a substrate body 30, wherein a surface thereof has a circuit layer comprising a plurality of circuits 33 and a plurality of conductive pads 34 is disposed, and the conductive pads 34 are higher than the circuits 33; and an insulating protection layer 37 disposed on the surface of the substrate body 30, and having a plurality of openings 371 exposing the conductive pads 34. The openings 371 of the protective layer 37 have a size equal to (FIG 3H') or larger than (FIG. 3H) that of the conductive pads 34.

As shown in FIGs. 3I and 3I', the conductive pads 34 in the packaging substrate of the present invention can further be processed by surface finish. A surface fmish layer 38 on the surfaces of the conductive pads 34 can be made of one selected from the group consisting of Ni/Au, OSP, ENIG, Ni/Pd/Au, Sn, solder, Pb-free solder, Ag, and a combination thereof.

Although the present invention has been explained in relation to its preferred embodiment, it is to be understood that many other possible modifications and variations can be made without departing from the scope of the invention as hereinafter claimed.

## Claims

1. A packaging substrate structure comprising:
a substrate body, wherein a surface thereof has a circuit layer comprising a plurality of circuits and a plurality of conductive pads, and the conductive pads are higher than the circuits; and
an insulating protection layer disposed on the surface of the substrate body and having a plurality of openings exposing the conductive pads.

2. The packaging substrate structure of claim 1, further comprising a conductive layer disposed underneath the circuit layer.

3. The packaging substrate structure of claim 1, wherein the insulating protection layer is one of a solder mask and a dielectric layer, and the size of the openings is equal to or larger than that of the conductive pads.

4. The packaging substrate structure of claim 1, further comprising a surface finish layer which is made of one selected from the group consisting of Ni/Au, organic solderability preservatives (OSP), electroless nickel immersion gold (ENIG), Ni/Pd/Au, Sn, solder, Pb-free solder, Ag, and a combination thereof, disposed on the conductive pads.

5. A method for manufacturing a packaging substrate comprising:
providing a substrate body and forming a conductive layer on the surface of a dielectric layer of the substrate body;
forming a first resistive layer on the conductive layer, and forming a plurality of open areas in the first resistive layer exposing parts of the conductive layer;
forming a circuit layer comprising a plurality of circuits and a plurality of conductive pads in the open areas through the conductive layer by electroplating;
forming a second resistive layer on the surfaces of the first resistive layer and the circuit layer, and forming a plurality of openings in the second resistive layer exposing the conductive pads;
forming a protective layer on the surfaces of the conductive pads;
removing the second resistive layer and the first resistive layer, then removing the conductive layer covered by the first resistive layer, at the same time thinning the circuits by micro-etching so that the conductive pads are higher than the circuits;
removing the protective layer; and
forming an insulating protection layer on the surface of the substrate body, and forming a plurality of openings in the insulating protection layer exposing the conductive pads.

6. The method of claim 5, wherein the protective layer is formed by electroplating.

7. The method of claim 5, wherein the protective layer is made of one selected from the group consisting of Sn, Ni, Au, Ag, Cr, and Ti.

8. The method of claim 5, further comprising forming a surface finish layer which is made of one selected from the group consisting of Ni/Au, OSP, ENIG, Ni/Pd/Au, Sn, solder, Pb-free solder, Ag, and a combination thereof, on the surfaces of the conductive pads.

9. The method of claim 5, wherein the insulating protection layer is one of a solder mask and a dielectric layer, and the size of the openings is equal to or larger than that of the conductive pads.
